(19) **Europäisches Patentamt**
**European Patent Office**
**Office européen des brevets**

(11) **EP 3 836 239 A1**

(12) **EUROPEAN PATENT APPLICATION**
published in accordance with Art. 153(4) EPC

(43) Date of publication:
**16.06.2021 Bulletin 2021/24**

(51) Int Cl.:
**H01L 51/44** (2006.01)     **H05B 33/06** (2006.01)

(21) Application number: **20820035.2**

(86) International application number:
**PCT/JP2020/030488**

(22) Date of filing: **07.08.2020**

(87) International publication number:
**WO 2021/075130 (22.04.2021 Gazette 2021/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **18.10.2019 JP 2019190903**

(71) Applicant: Enecoat Technologies Co.,Ltd.
**Kamigyo-ku**
**Kyoto-shi, Kyoto 602-0853 (JP)**

(72) Inventors:
• **MIKI, Masako**
**Kyoto-shi, Kyoto 602-0853 (JP)**
• **TAKAHAMA, Tsuyoshi**
**Kyoto-shi, Kyoto 602-0853 (JP)**
• **YABUMOTO, Toshihiko**
**Kyoto-shi, Kyoto 602-0853 (JP)**

(74) Representative: **Peters, Sebastian Martinus**
**Octrooibureau Vriesendorp & Gaade B.V.**
**Koninginnegracht 19**
**2514 AB Den Haag (NL)**

(54) **ELEMENT**

(57)     [Problem] To provide an element cell which allows for a terminal to be connected without peeling of a back-side electrode when connecting the terminal from the element such as a solar to the outside or when estimating the performance of the element.

[Solution] An element including: a substrate 3; a transparent electrode 5a, 5b provided on the substrate 3; a photoelectric conversion layer 7, 9, 11; and a back-side electrode 13. The transparent electrode 5a, 5b includes a first transparent electrode part 5a and a second transparent electrode part 5b which are spatially separated from each other. The photoelectric conversion layer 7, 9, 11 is formed on the first transparent electrode part 5a. The back-side electrode 13 includes: an electrode main body part 13a which is present on the photoelectric conversion layer 11; an electrode connecting part 13b which contacts the second transparent electrode part; and a bridge 13c that connects the electrode main body part 13a and the electrode connecting part 13b.

Fig.1

**Description**

TECHNICAL FIELD

The present invention relates to an element such as a solar cell.

BACKGROUND ART

When connecting the terminals to an element such as a solar cell, or when estimating the performance of an element, it is necessary to take one of the terminals from a back-side electrode, and to this end, it is necessary to pinch the back-side electrode with clip-shaped electrodes or to press the back-side electrode with a pin-shaped electrode. There has been a problem in that when doing the above, a back-side electrode made of a metal or the like which is formed by vapor deposition, etc. may be peeled off.

JP2018-163938A discloses a solar cell having a structure of a laminate in which an electrode, a counter electrode, and a photoelectric conversion layer therebetween are arranged, wherein a sealing layer covers the counter electrode.

There is a problem with solar cells in that the conversion efficiency and output deteriorates under high temperature and high humidity, and as is disclosed in JP2018-163938A, a technique is known for protecting a power generation unit from external factors using a sealing material in order to extend the life of the solar cell. However, there has been a problem in that it is difficult to connect a terminal to a back-side electrode which has been sealed.

PRIOR ART DOCUMENTS

PATENT DOCUMENTS

Patent Document 1: JP2018-163938A

SUMMARY OF INVENTION

TECHNICAL PROBLEM

Thus, an object of an invention described in this specification is to provide an element such as a solar cell of a shape which enables a terminal to be connected without peeling off a back-side electrode.

Another object of an invention described in this specification is to provide an element such as a solar cell having a shape which enables a terminal to be connected even though the element is covered with a sealing material layer. A further object of an invention described in this specification is to provide an element such as a solar cell which exhibits little reduction or variation in performance.

SOLUTION TO PROBLEM

The present invention is fundamentally based on the following findings.

First, if a terminal of an element is present at a location separated from a back-side electrode, then a situation in which the back-side electrode is peeled off when connecting the terminal or when estimating the performance of the battery can be prevented. Further, in conventional solar cells, it was believed that reductions in performance or variations in performance are caused by leaks. Such leaks were believed to occur due to, for example, contact between the back-side electrode and an electron transport layer that forms a photoelectric conversion layer, or due to the back-side electrode crossing an end of a perovskite layer/hole transport layer. Therefore, the above-mentioned leaks can be prevented by narrowing the width of a region in which the back-side electrode crosses an end of a perovskite layer/hole transport layer so that the electron transport layer and the back-side electrode do not contact each other, which in turns enables performance reductions and performance variations to be prevented.

An invention described in this specification relates to an element including: a substrate 3; a transparent electrode 5a, 5b provided on the substrate 3; a photoelectric conversion layer (layer which includes an electron transport layer 7, a photoactive layer 9, and a hole transport layer 11); and a back-side electrode 13. The transparent electrode 5a, 5b includes a first transparent electrode part 5a and a second transparent electrode part 5b which are spatially separated from each other. The photoelectric conversion layer 7, 9, 11 is formed on the first transparent electrode part 5a.

The back-side electrode 13 includes: an electrode main body part 13a which is present on the photoelectric conversion layer 11; an electrode connecting part 13b which contacts the second transparent electrode part; and a bridge 13c that connects the electrode main body part and the electrode connecting part.

A transparent electrode of ITO, etc. is spatially separated into the first transparent electrode part 5a and the second transparent electrode part 5b. Therefore, a terminal can be connected to the first transparent electrode part 5a, and from the second transparent electrode part 5b to which the electrode connecting part 13b of the back-side electrode is electrically connected. Given this, it is not necessary to connect a terminal to the back-side electrode 13, and thus the back-side electrode does not easily become peeled off. Since the back-side electrode 13 is shaped so as to be divided into two parts and connected with a bridge, and the bridge is shaped to as to cross an end of the photo-electrode conversion layer, leaks can be kept to a minimum.

In a preferred example of the above-described element, when the width of the electrode main body part is W, a width WB of the bridge is 0.01 W to 0.8 W. If the back-side electrode is not separated, then leaks can occur as described above. On the other hand, if the bridge is too narrow, the resistance may become too high, and this hinders the transmission of power. Therefore, the width of the bridge is preferably set to the above-mentioned range.

In a preferred example of the above-described element, the average layer thickness of the back-side electrode 13 is 20 nm to 250 nm.

In a preferred example of the above-described element, the back-side electrode 13 contains gold, and the average layer thickness of the back-side electrode 13 is 100 nm to 200 nm. In such an element, for example, a high output was able to be achieved regardless of whether the illuminance of incident light is intense or weak, such as when an intense light of 1 Sun or a weak light of 200 Lx is irradiated.

A preferred example of the above-described element further includes a sealing material layer that covers the transparent electrode and the back-side electrode. Due to this configuration, the perovskite layer can be made compact. Further, as mentioned above, the life of the element can be extended by incorporating a sealing material layer.

In a preferred example of the above-described element, the photoelectric conversion layer includes the electron transport layer 7, the perovskite layer 9, and the hole transport layer 13.

In a preferred example of the above-described element, the electrode main body part 13a and the bridge 13c do not contact the first transparent electrode part 5a and the electron transport layer 7.

A preferred example of the above-described element is a solar cell including the element.

EFFECTS OF INVENTION

This specification can provide an element such as a solar cell of a shape which allows for a back-side electrode to not be peeled off when connecting a terminal to the element or when estimating the performance of the element.

This specification also can provide an element such as a solar cell which exhibits little reduction or variation in performance.

BRIEF DESCRIPTION OF DRAWINGS

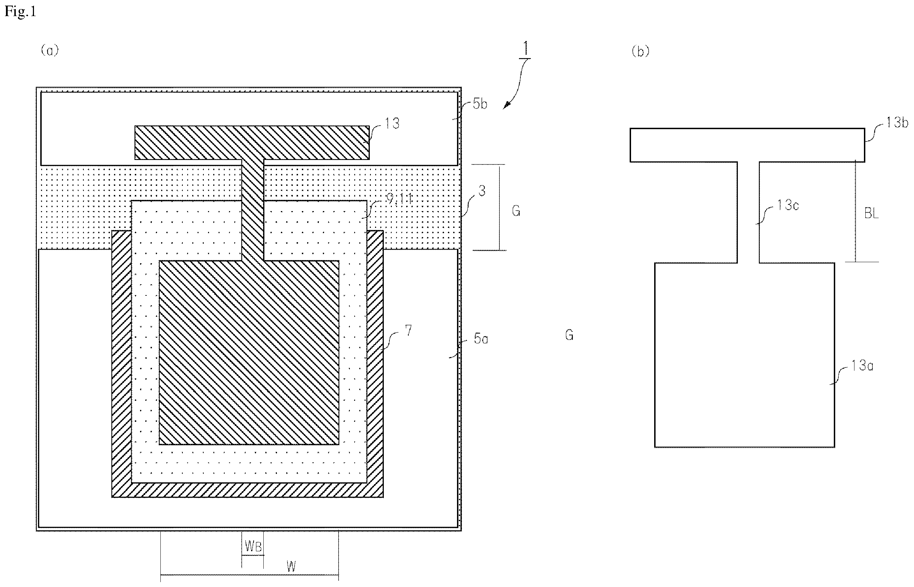

FIG. 1 is a schematic view illustrating a configurational example of an element of the present invention. FIG. 1(a) is a top surface view of the element, and FIG. 1(b) shows a back-side electrode.

DESCRIPTION OF EMBODIMENTS

In the following, embodiments for carrying out the present invention shall be described using drawings. The present invention is not limited to the embodiments described below, and may be appropriately modified from the embodiments below within a scope that would be obvious to a person skilled in the art.

FIG. 1 is a schematic view illustrating a configurational example of an element of the present invention. FIG. 1(a) is a top surface view of the element, and FIG. 1(b) shows a back-side electrode. As shown in FIG. 1(a), an example of an element 1 relates to an element including: a substrate 3; a transparent electrode 5a, 5b provided on the substrate 3; a photoelectric conversion layer 7, 9, 11 which includes an electron transport layer 7, a photoactive layer 9, and a hole transport layer 11, and which converts light and electricity; and a back-side electrode 13. The transparent electrode 5a, 5b consists of a first transparent electrode part 5a and a second transparent electrode part 5b which are spatially separated from each other. The photoelectric conversion layer 7, 9, 11 is formed on the first transparent electrode part 5a. Herein, the photoelectric conversion layer 7, 9, 11 being "formed on the first transparent electrode part 5a" means that a portion of the photoelectric conversion layer 7, 9, 11 can be formed on top of the first transparent electrode part 5a, or that the entirety of the photoelectric conversion layer 7, 9, 11 can be formed on top of the first transparent electrode part 5a. In the example of FIG. 1(a), most of the bottommost layer (the electron transport layer 7 in the example of FIG. 1(a)) of the photoelectric conversion layers is formed on top of the first transparent electrode part 5a, and a portion of the bottommost layer 7 of the photoelectric conversion layers protrudes from the first transparent electrode part 5a toward the second transparent electrode part 5b. Further, most of the upper layers (the photoactive layer 9 and the hole transport layer 11 in the example of FIG. 1(a)) of the photoelectric conversion layers is formed on top of the first transparent electrode part 5a and the bottommost layer 7 of the photoelectric conversion layers, and a portion of the upper layers of the photoelectric conversion layers protrudes from the first transparent electrode part 5a and the bottommost layer 7 of the photoelectric conversion layers toward the second transparent electrode part 5b. In the example of FIG. 1(a), the width of the bottommost layer 7 of the photoelectric conversion layers is narrower than the width of the first transparent electrode part 5a, and the width of the upper layers of the photoelectric conversion layers is narrower than the width of the bottommost layer 7 of the photoelectric conversion layers. These elements exhibit a shape that is approximately linearly symmetrical with respect to a center line.

Examples of the element 1 include a solar cell and an organic EL element. Examples of the solar cell include a perovskite solar cell. A perovskite solar cell includes, for example, the following, in this order: a transparent electrode; a (hole) blocking layer; an electron transport layer; a perovskite layer (light absorbing layer); a hole transport layer; and a back-side electrode. The perovskite solar cell may be of an ordered type in which an n-type semiconductor layer is provided on the transparent electrode, or may be of the inverse type in which a p-type semiconductor layer is provided on the transparent electrode. In the following, the perovskite solar cell shall be explained using, as an example, a perovskite solar cell including the following, in this order: a transparent electrode; a (hole) blocking layer; an electron transport layer; a perovskite layer (light absorbing layer); a hole transport layer; and a back-side electrode.

Organic EL elements are publicly-known elements as disclosed in, for example, JP2017-123352A and JP2015-071619A, and methods for manufacturing these elements are also publicly known. An example of the organic EL element includes: a substrate; a positive electrode; a negative electrode; and an organic layer disposed between the positive electrode and the negative electrode. The organic layer is constituted by laminating, in order from the positive electrode side, a hole injection layer, a hole transport layer, a light-emitting layer, an electron transport layer, and an electron injection layer.

Substrate

As the substrate 3, a publicly-known substrate for a perovskite solar cell or an organic EL element may be appropriately used. Examples of the substrate include a glass substrate, an insulator substrate, a semiconductor substrate, a metallic substrate, and an electrically-conductive substrate (including an electrically-conductive layer). Further, a substrate in which at least one of a metallic layer, a semiconductor layer, an electrically-conductive layer, and an insulating layer is formed on part or all of the surface of the above substrates may also be suitably used.

Examples of a metal constituting the metallic layer include one or two or more metals selected from gallium, iron, indium, aluminum, vanadium, titanium, chromium, rhodium, nickel, cobalt, zinc, magnesium, calcium, silicon, yttrium, strontium and barium. Examples of a material constituting the semiconductor layer include a single element such as silicon and germanium, compounds including an element from Groups 3 to 5 and Groups 13 to 15 of the periodic table, a metal oxide, a metal sulfide, a metal selenide, a metal nitride, and the like. Examples of a material constituting the electrically-conductive layer include tin-doped indium oxide (ITO), fluorine-doped indium oxide (FTO), zinc oxide (ZnO), aluminum-doped zinc oxide (AZO), gallium-doped zinc oxide (GZO), tin oxide ($SnO_2$), indium oxide ($In_2O_3$), and tungsten oxide ($WO_3$). Examples of a material constituting the insulating layer include aluminum oxide ($Al_2O_3$), titanium oxide ($TiO_2$), silicon oxide ($SiO_2$), silicon nitride ($Si_3N_4$), and silicon oxynitride ($Si_4O_5N_3$).

Examples of the shape of the substrate include plate-shaped such as a flat plate or a disc, fiber-shaped, rod-shaped, column-shaped, prism-shaped, cylinder-shaped, spiral-shaped, sphere-shaped, and ring-shaped, and the substrate may also have a porous structure. In the present invention, among the above, a plate-shaped substrate is preferred. An example of the thickness of the substrate is preferably 0.1 $\mu$m to 100 mm, and more preferably 1 $\mu$m to 10 mm.

Transparent Electrode

The transparent electrode 5a, 5b is provided on the substrate 3. At this time, the transparent electrode 5a, 5b may be provided directly on the substrate 3, or may be provided on the substrate 3 with some kind of layer therebetween. The transparent electrodes are support bodies for the electron transport layer, and are also a layer having a function to extract a current (electrons) from the perovskite layer (light absorbing layer) via the (hole) blocking layer. Therefore, the transparent electrodes are preferably an electrically-conductive substrate, or a transparent electrically-conductive layer having translucence such that light which contributes to photoelectric conversion can pass therethrough.

As the transparent electrically-conductive layer, mention may be made of, for example, a tin-doped indium oxide (ITO) layer, an impurity-doped indium oxide ($In_2O_3$) layer, an impurity-doped zinc oxide (ZnO) layer, a fluorine-doped tin dioxide (FTO) layer, and a laminated layer in which the above layers are laminated. The thickness of the transparent electrically-conductive layer is not particularly limited, and it is normally preferable to adjust the thickness so that the sheet resistance is 5 to 15 $\Omega/\square$ (per unit area). The transparent electrically-conductive layer may be obtained by a publicly-known layer forming method according to the material to be formed.

The transparent electrically-conductive layer may be covered with a translucent coating material as necessary to protect the transparent electrically-conductive layer from the outside. As such a translucent coating material, mention may be made of, for example, a resin sheet of a fluororesin, polyvinyl chloride, or polyimide, etc., an inorganic sheet such as a white glass plate or a soda glass, and a hybrid sheet combining these materials. The thickness of the translucent coating material is not particularly limited, and it is normally preferable to adjust the thickness so that the resistance is 5 to 15 $\Omega/\square$.

A hole blocking layer may be provided between the transparent electrode layer and the electron transport layer. The (hole) blocking layer is a layer which is provided to prevent hole leaks, to suppress reverse currents, and to improve the solar cell characteristics (especially the photoelectric conversion efficiency), and the (hole) blocking layer is preferably provided between the transparent electrodes and the perovskite layer (light absorbing layer). The (hole) blocking layer is preferably made of a metal oxide such as titanium oxide, and is more preferably a layer consisting of an n-type semiconductor of compact $TiO_2$ or the like that smoothly and densely covers the surface of the transparent electrodes. Herein, "densely" indicates that the metal compound is filled in a higher density than the density in which the metal compound in the electron transport layer is filled. As long as the transparent electrodes and the electron transport layer do not become electrically connected, pin holes and cracks, etc. may be present in the (hole) blocking layer.

The layer thickness of the (hole) blocking layer is, for example, 5 to 300 nm. The layer thickness of the (hole) blocking layer is more preferably 10 to 200 nm in view of the efficiency of electron injection to the electrode.

The (hole) blocking layer is formed on the transparent electrodes. If a metal oxide is used for the (hole) blocking layer, then the (hole) blocking layer can be produced by, for example, performing spray pyrolysis in accordance with a known method (e.g. Non-Patent Document 4: J. Phys. D.: Appl. Phys. 2008, 41, 102002, etc.). For example, the (hole) blocking layer can be produced by spraying an alcohol solution (e.g. an isopropyl alcohol solution, etc.) containing 0.01 to 0.40 M (particularly 0.02 to 0.20 M) of a metal alkoxide (e.g. a titanium alkoxide such as titanium di(isopropoxide) bis(acetylacetonate)) onto a transparent electrode placed on a hot plate heated to 200 to 550°C (particularly 300 to 500°C).

Thereafter, a more dense layer can be obtained by immersing the obtained substrate in an aqueous solution of a titanium oxide ($TiO_2$, etc.), a titanium alkoxide (titanium isopropoxide, etc.), and a titanium halide ($TiCl_4$, etc.) and heating the substrate.

The concentration of the raw ingredient in the aqueous solution including the raw ingredient of the (hole) blocking layer is preferably 0.1 to 1.0 mM, and more preferably 0.2 to 0.7 mM. Further, the immersion temperature is preferably 30 to 100°C, and more preferably 50 to 80°C. In addition, the heating conditions are preferably 5 to 60 minutes (particularly 10 to 30 minutes) at 200 to 1000°C (particularly 300 to 700°C).

Electron Transport Layer

The electron transport layer 7 is formed to increase the active surface area of the perovskite layer (light absorbing layer) and improve the photoelectric conversion efficiency, as well as to facilitate electron collection. The electron transport layer may be formed on the substrate, but also may be formed on the (hole) blocking layer. The (hole) blocking layer may function as the electron transport layer, and the electron transport layer may also serve as the (hole) blocking layer. The electron transport layer may be a flat layer which uses an organic semiconductor material such as a fullerene derivative. The electron transport layer may also be a layer consisting of a metal oxide such as titanium oxide (TiO2) (including mesoporous TiO2), tin oxide (SnO2), and zinc oxide (ZnO).

If the metal compound is a semiconductor, the electron transport layer can also be doped with a donor. By doing so, the electron transport layer becomes a window layer for introduction to the perovskite layer (light absorbing layer), and the power obtained from the perovskite layer (light absorbing layer) can be more efficiently extracted.

The thickness of the electron transport layer is not particularly limited, and in view of enabling better collection of electrons from the perovskite layer (light absorbing layer), the thickness is preferably about 10 to 300 nm, and more preferably about 10 to 50 nm. The electron transport layer can be obtained using a publicly-known layer forming method according to the material to be formed. For example, the electron transport layer can be produced by applying an aqueous dispersion of 3 to 15% by mass (particularly 5 to 10% by mass) of tin oxide microparticles onto a transparent electrode. A publicly-known or commercially-available tin oxide microparticle aqueous dispersion can be used. The application method is preferably spin coating. The application is performed at, for example, approximately 15 to 30 °C.

Photoactive Layer

The perovskite layer (photoactive layer, light absorbing layer) 9 of the perovskite solar cell is a layer that performs photoelectric conversion by absorbing light and causing excited electrons and holes to move. The perovskite layer (light absorbing layer) contains a perovskite material or a perovskite complex. A mixed liquid is preferably applied onto a substrate by spin coating, dip coating, screen printing, roll coating, die coating, transfer printing, spraying, or slit coating, and among these spin coating is preferable.

The layer thickness of the perovskite layer (photoactive layer, light absorbing layer) is, for example, preferably 50 to 1000 nm, and more preferably 200 to 800 nm, in consideration of the balance between the light absorption efficiency and the exciton diffusion length, as well as the absorption efficiency of light reflected by the transparent electrodes. The layer thickness of the perovskite layer (light absorbing layer) of the present invention is preferably in the range of 100 to 1000 nm, and more preferably in the range of 250 to 500 nm. The layer thickness of the perovskite layer (photoactive layer, light absorbing layer) of the present invention is measured by cross-sectional scanning electron microscopy (cross-sectional SEM) of the layer.

Further, the flatness of the perovskite layer (photoactive layer, light absorbing layer) of the present invention preferably exhibits a height difference of no more than 50 nm (-25 nm to +25 nm), and more preferably no more than 40 nm (-20 nm to +20 nm), in the range of 500 nm × 500 nm in the horizontal direction of the surface that was measured by the scanning electron microscope. This facilitates achieving a balance between the light absorption efficiency and the exciton diffusion length, and enables the absorption efficiency of light reflected by the transparent electrodes to be improved. The "flatness" of the perovskite layer (light absorbing layer) is measured by cross-sectional scanning electron microscopy (cross-sectional SEM) of the perovskite layer (light absorbing layer) of the present invention, wherein an arbitrarily determined measurement point is used as a reference point, and the difference from the reference point at a location in the measurement range where the layer thickness is greatest is set as the upper limit value, and the difference from the reference point at a location in the measurement range where the layer thickness is smallest is set as the lower limit value.

A tin-based perovskite layer includes, in a total amount of 0.01 ppm to 1000 ppm, one or two or more selected from zero-valent tin, a pyrazine-based compound, a silicon-based compound, and a germanium-based compound. The tin-based perovskite layer can be obtained based on the method for manufacturing a tin-based perovskite layer described above, and residuals such as a reducing agent are present in prescribed amounts. When prescribed amounts of specific substances remain therein, the tin-based perovskite layer exhibits excellent passivation. The content of these substances can be analyzed by performing a component analysis of the tin-based perovskite layer. In the embodiments explained below, a tin-based perovskite layer was actually obtained. There is criticality in the content of the above-mentioned substances (there is a significant difference in the passivation depending on whether the content is within or outside of the above-mentioned numerical value range). Examples of pyrazine-based compounds and silicon-based compounds include the compounds shown in formula (I) to formula (V). The germanium-based compounds include the germanium-based reducing agents mentioned above, as well as compounds generated when a compound in solution reacts with such reducing agents. The total amount of the above may be 0.1 ppm to 500 ppm, or may be 1 ppm to 500 ppm. A light-emitting material or a photoelectric conversion element having such a tin-based perovskite layer takes advantage of the above-described characteristics to exhibit good characteristics. The perovskite layer is not limited to a tin-based perovskite layer, and a perovskite layer consisting of some other material such as a lead-based perovskite layer may be used.

Hole Transport Layer

The hole transport layer 11 is a layer having a function of transporting a charge. For the hole transport layer, for example, a conductor, a semiconductor, an organic hole transport material, and the like can be used. These materials can function as a hole transport material that receives a hole from the perovskite layer (light absorbing layer) and transports the hole. The hole transport layer is formed on the perovskite layer (light absorbing layer). As the conductor and semiconductor, mention may be made of, for example: a compound semiconductor containing a monovalent copper such as CuI, CuInSe2, and CuS; and compounds containing a metal other than copper such as GaP, NiO, CoO, FeO, Bi2O3, MoO2, and Cr2O3. Among these, in view of more efficiently receiving only holes and achieving a higher hole mobility, a semiconductor containing a monovalent copper is preferable, and CuI is more preferable. As the organic hole transport material, mention may be made of, for example: polythiophene derivatives such as poly-3-hexylthiophene (P3HT) and polyethylene dioxythiophene (PEDOT); fluorene derivatives such as 2,2',7,7'-tetrakis-(N,N-di-p-methoxyphenylamine)-9,9'-spirobifluorene (Spiro-OMeTAD); carbazole derivatives such as polyvinylcarbazole; triphenylamine derivatives such as poly[bis(4-phenyl)(2,4,6-trimethylphenyl)amine] (PTAA); diphenylamine derivatives; polysilane derivatives; and polyaniline derivatives. Among these, in view of more efficiently receiving only holes and achieving a higher hole mobility, triphenylamine derivatives and fluorene derivatives, etc. are preferable, and PTAA, Spiro-OMeTAD, etc. are more preferable.

In the hole transport layer, for the purpose of further improving the hole transport characteristics, an oxidizing agent such as lithium bis (trifluoromethylsulfonyl) imide (LiTFSI), silver bis (trifluoromethylsulfonyl) imide, trifluoromethylsulfonyloxy silver, $NOSbF_6$, $SbCl_5$, $SbF_5$, and tris (2-(1H-pyrazol-1-yl)-4-tert-butylpyridine) cobalt (III) tri [bis(trifluoromethane)sulfonimide] can be incorporated. Further, in the hole transport layer, a basic compound such as t-butylpyridine (TBP), 2-picoline, and 2,6-lutidine can also be incorporated. The amount of the oxidizing agent and the basic compound to be incorporated can be set to an amount that is normally used in the prior art. In view of more efficiently receiving only holes and achieving a higher hole mobility, the layer thickness of the hole transport layer is, for example, preferably 50 to 500 nm, and more preferably 100 to 300 nm. The method for forming the hole transport layer is preferably, for example, performed in a dry atmosphere. For example, it is preferable to apply (by spin coating, etc.) a solution containing an organic hole transport material onto the perovskite layer (light absorbing layer) in a dry atmosphere, and then heat at 30 to 180°C (particularly 100 to 150°C).

The electron transport layer 7, the perovskite layer 9, and the hole transport layer 13 may be formed, in this order, on the transparent electrode 5a, 5b. Further, the electron transport layer 7, the perovskite layer 9, and the hole transport layer 13 may also be formed on the transparent electrode 5a, 5b in the order of the hole transport layer 13, the perovskite layer 9, and the electron transport layer 7. The photoelectric conversion layers may be constituted by only the electron transport layer 7, the perovskite layer 9, and the hole transport layer 13, or may appropriately include a layer(s) besides the electron transport layer 7, the perovskite layer 9, and the hole transport layer 13.

Back-Side Electrode

The back-side electrode 13 is an electrode which may also be referred to as a metallic electrode if it is metal. The back-side electrode is disposed opposing the transparent electrodes and is formed on the hole transport layer, and thereby charge exchange can be performed with the hole transport layer. As the back-side electrode, a publicly-known material used in the relevant industry can be used, and mention may be made of, for example, a metal such as platinum, titanium, stainless steel, aluminum, gold, silver, and nickel, or an alloy of such metals. Among these, the metallic electrode is preferably a material that can be formed by a method such as vapor deposition, since this allows the electrode to be formed in a dry atmosphere.

Sealing Material Layer

A sealing material layer is provided to protect the photoelectric conversion portion. Examples of a material for constituting the sealing material layer include: thermoplastic resins such as ethylene-vinyl acetate copolymer (EVA), polyvinyl butyral (PVB), polyethylene terephthalate (PET), polyolefin (PO), and polyimide (PI); thermosetting resins such as epoxy, urethane, and polyimide; and an inorganic material such as glass. EVA, PO, and glass are preferable.

The thickness of the sealing material layer is, for example, preferably 0.1 to 10 mm, and more preferably 0.2 to 1.0 mm. A sealing material layer with this degree of thickness can sufficiently seal and protect the photoelectric conversion portion.

The tensile elastic modulus of the sealing material layer is, for example, preferably 0.005 to 0.05 GPa, and more preferably 0.01 to 0.05 GPa. When the tensile elastic modulus of the sealing material layer is in such a range, stress caused by expansion/contraction of a surface protection substrate can be sufficiently relaxed.

The element may further include a surface protection layer or a surface protection substrate.

As shown in FIG. 1(a), the transparent electrode 5a, 5b includes the first transparent electrode part 5a and the second transparent electrode part 5b which are spatially separated from each other. The first transparent electrode part 5a is normally an electrode on which the photoelectric conversion portion is constructed. The size and shape of the first transparent electrode part 5a are arbitrary, but the size preferably allows for the photoelectric conversion portion to be constructed thereon. A distance G between the first transparent electrode part 5a and the second transparent electrode part 5b can be appropriately adjusted according to the size of the element. However, if this distance G is too small, the back-side electrode cannot be sufficiently separated, and the electrode main body part 13a and the bridge 13c cannot ensure a state in which the first transparent electrode part 5a and the electron transport layer 7 are not in contact. Therefore, when the width of the electrode main body part 13a to be explained below (the width in a direction perpendicular to the longitudinal direction of the bridge 13c) is W, the distance G is preferably 0.1 W to 1 W, and may be 0.2 W to 0.9 W or 0.3 W to 0.8 W. If the shape of the electrode main body part is circular, elliptical, polygonal, irregular, or the like, the width based on the shape of the electrode main body part 13a in FIG. 1(a) can be defined as W.

As shown in FIG. 1(b), the back-side electrode 13 includes: the electrode main body part 13a which is present on the hole transport layer 11; the electrode connecting part 13b which is electrically connected to the second transparent electrode part 5b; and the bridge 13c that connects the electrode main body part 13a and the electrode connecting part 13b. The electrode main body part 13a is normally provided on the layers formed on the first transparent electrode part 5a. The electrode connecting part 13b is normally provided on the second transparent electrode 5b.

Since the transparent electrode of ITO, etc. is spatially separated into the first transparent electrode part 5a and the second transparent electrode part 5b, a terminal can be connected to the first transparent electrode part 5a, and to the second transparent electrode 5b to which the electrode connecting part 13b of the back-side electrode is electrically connected, respectively, or connected with an sample device when the terminal is connected to the element or when the performance of the element is estimated. Thus, the electrode main body part 13a does not easily become peeled off. Since the back-side electrode 13 is shaped so as to be divided into two parts and connected with a bridge, and the bridge is shaped so as to cross an end of the perovskite layer 9/hole transport layer 11, leaks can be kept to a minimum.

In a preferred example of the above-described element, when the width of the electrode main body part 13a is W, a width $W_B$ of the bridge is 0.01 W to 0.8 W, and the width $W_B$ may be 0.05 W to 0.5 W, 0.05 W to 0.3 W, or 0.1 W to 0.3 W. If the back-side electrode is not separated, then there is a higher possibility of an increase in leak points as described above. On the other hand, if the bridge is too narrow, the resistance may become too high, and this hinders the transmission of power. Therefore, the width of the bridge is preferably set to the above-mentioned ranges.

In a preferred example of the above-described element, the average layer thickness of the back-side electrode 13 is 20 nm to 250 nm.

In a preferred example of the above-described element, the back-side electrode 13 contains gold, and the average layer thickness of the back-side electrode 13 is 100 nm to 200 nm. In such an element, for example, a high output was able to be achieved regardless of whether the illuminance of incident light is intense or weak, such as when an intense light of 1 Sun or a weak light of 200 Lx is irradiated.

In a preferred example of the above-described element, the electrode main body part 13a and the bridge 13c do not contact the first transparent electrode part 5a and the electron transport layer 7. In order to configure the electrode main body part 13a so that it does not contact the first transparent electrode part 5a and the electron transport layer 7, the perovskite layer 9 and the hole transport layer 11 are formed over a wider area than the electrode main body part 13a as shown in FIG. 1(a). Further, at the very least, the perovskite layer 9 and the hole transport layer 11 cover the electron transport layer 7 in the region in which the electrode main body part 13a exists. Due to this configuration, the electrode main body part 13a does not contact the first transparent electrode part 5a and the electron transport layer 7. In order to configure the bridge 13c so that it does not contact the first transparent electrode part 5a and the electron transport layer 7, the perovskite layer 9 and the hole transport layer 11 cover the electron transport layer 7 in the region in which the bridge 13c exists. Further, as shown in FIG. 1(a), the ends on the second transparent electrode part 5b side of the perovskite layer 9 and the hole transport layer 11 are preferably closer to the second transparent electrode part 5b than the end on the second transparent electrode part 5b side of the electron transport layer 7.

A length BL of the bridge 13c (i.e., the distance between the electrode main body part 13a and the electrode connecting part 13b) is preferably 0.1 W to 1.5 W, and may be 0.2 W to 1.2 W, or 0.3 W to 1 W, or 0.8 W to 1.2 W.

A preferred example of the above-described element further includes a sealing material layer that covers the transparent electrodes and the back-side electrode. Due to this configuration, the perovskite layer can be made compact. Further, as mentioned above, the life of the element can be extended by incorporating a sealing material layer.

In a preferred example of the above-described element, the element is a solar cell.

Methods for manufacturing a solar cell and an organic EL element are widely known in addition to those described in the documents mentioned in this specification. Therefore, the element described in this specification can be manufactured appropriately using a publicly-known method.

EMBODIMENT 1

The photoelectric conversion characteristics of the solar cells of Embodiments 1 and 2 and Comparative Embodiment 1 were measured by a method based on the output measurement method of a silicon crystal-based solar cell set forth in JIS C 8913:1998. An air mass filter equivalent to AM 1.5 G was assembled in a solar simulator (SMO-250 PV manufactured by Bunkoukeiki Co., Ltd.), and a measurement light source was adjusted to a light amount of 100 mW/cm$^2$ with a secondary reference Si solar cell. Light was irradiated on a test sample of a perovskite solar cell, and the I-V curve characteristics were measured using a source meter (2400 Series Universal SourceMeter manufactured by Keithley Instruments Inc.). Next, the short-circuit current (Isc), open-circuit voltage (Voc), fill factor (FF), series resistance (Rs), and parallel resistance (Rsh) obtained from the measurement of the I-V curve characteristics were derived. The short-circuit current density (Jsc) and photoelectric conversion efficiency (PCE) were calculated using the following Equations 1 and 2.

$$\text{Equation 1: short-circuit current density (Jsc; mA/cm}^2\text{)} = \text{Isc (mA) / effective light-receiving surface S (cm}^2\text{)}$$

$$\text{Equation 2: photoelectric conversion efficiency (PCE; \%)} = \text{Voc (V)} \times \text{Jsc (mA/cm2)} \times \text{FF} \times 100 / 100 \text{ (mW/cm2)}$$

An element for a solar cell like that shown in FIG. 1 was manufactured. The manufacturing method is as described below.

**EP 3 836 239 A1**

An ITO-coated glass substrate (25 mm × 24.5 mm, Geomatec) was ultrasonically washed in 2-propanol, acetone, Semicoclean 56, water, and 2-propanol in this order for 15 minutes each. Finally, the ITO-coated glass substrate was cleaned with UV ozone for 15 minutes.

The electron transport layer was formed by applying, onto the ITO substrate, 320 μL of a solution, which was obtained by diluting an aqueous dispersion of tin oxide microparticles (Alfa Aesar 44592) with pure water and then filtering with a PTFE filter, and then spin coating was performed (the spin coating was carried out for 30 seconds at 2000 rpm with a 2-second slope, and then stopped with a 2-second slope). Subsequently, after removing any unnecessary portions so as to achieve the shape of the electron transport layer 7 shown in FIG. 1(a), the substrate was heated for 30 minutes at 150°C, and thus the electron transport layer was formed. The resulting substrate was placed in a glove box, and then the perovskite layer was formed.

CsI, MABr, PbBr$_2$, PbBr$_2$, and FAI were dissolved in a mixed solvent of DMF and DMSO (volume ratio of 10:3), and the solution was adjusted to a concentration of 1.05 M. After filtering with a PTFE filter, 190 μL of the solution was applied onto the substrate on which the electron transport layer was formed, and then spin coating was performed (the spin coating was carried out for 10 seconds at 1000 rpm with a 1-second slope, and then again for 20 seconds at 3000 rpm with a 5-second slope). During the spin coating, 300 μL of chlorobenzene was dropped onto the substrate. Thereafter, the substrate was heated for 10 minutes at 150°C, and thus the perovskite layer was formed. The resulting substrate was placed in a glove box, and then the hole transport layer was formed. A solution obtained by dissolving 72.3 mg of the hole transport material Spiro-OMeTAD, 13.5 mg of [tris(2-(1H-pyrazol-1-yl)-4-tert-butylpyridine)-cobalt(III)tris (bis-(trifluoromethyl-sulfonyl)imide)] (FK 209), 28.8 μL of TBP, and 9.1 mg of LiTFSI in 1 mL of chlorobenzene was stirred for 30 minutes and then filtered with a PTFE filter. 90 μL of the resulting solution was spin coated on the perovskite layer (the spin coating was carried out for 30 seconds at 4000 rpm with a 4-second slope, and then stopped with a 4-second slope), and then annealed for 30 minutes at 70°C. Subsequently, after removing any unnecessary portions so as to achieve the shape of the perovskite layer 9 and the hole transport layer 11 shown in FIG. 1(a), a 120 nm gold electrode was attached thereto by vacuum deposition, thereby yielding the perovskite solar cell.

The element manufactured by the manufacturing method described above was as follows. The substrate 3 was glass. The first transparent electrode part 5a and the second transparent electrode part 5b were ITO layers. The size of one element was 25 mm × 24.5 mm. The size of the first transparent electrode part 5a was 25 mm × 15.5 mm. The size of the second transparent electrode part 5b was 25 mm × 4 mm. The thickness of the transparent electrode part 5 was 150 nm. The distance G between the first transparent electrode part 5a and the second transparent electrode part 5b was 5 mm. The size of electron transport layer 7 was 16 mm × 15 mm, and the thickness was 50 nm. The size of the perovskite layer 9 and the hole transport layer 11 was 14 mm × 16 mm, and the thicknesses thereof were 400 nm and 50 nm, respectively. The size of the electrode main body part 13a was 10.5 mm × 10.5 mm, the size of electrode connecting part 13b was 14 mm × 2 mm, and the size of the bridge 13c was 1 mm × 6 mm. The average layer thickness of the back-side electrode was 120 nm.

With regard to the power generation performance values, a conversion efficiency at 1 Sun of 13.2% was realized, and a maximum output at 200 lux of 16 μW/cm$^2$ was realized. The output of the element which exhibited the lowest maximum output among 9 elements tested was 10.5 μW/cm$^2$, and variations between elements were able to be suppressed.

EMBODIMENT 2

An element was produced in the same manner as that of Embodiment 1 except that the average layer thickness of the back-side electrode was 80 nm. As a result, with regard to the power generation performance values, a conversion efficiency at 1 Sun of 7.9% was realized, and a maximum output at 200 lux of 16.3 μW/cm$^2$ was realized. Considering Embodiment 1, it can be understood that the average layer thickness of the back-side electrode is preferably from 100 nm to 200 nm because the high maximum output can be achieved regardless of whether the illuminance of incident light is intense or weak, such as when an intense light of 1 Sun or a weak light of 200 Lx is irradiated.

[Comparative Embodiment 1]

An element for a solar cell was manufactured in the same manner as Embodiment 1, except that the width WB of the bridge was the same as the width W of the electrode main body 13a and the bridge 13c was in contact with the electron transport layer 7. The maximum output at 200 lux of the resulting element was 3.5 μW/cm2.

INDUSTRIAL APPLICABILITY

The present invention can be utilized in the field related to solar cells and organic EL elements.

9

REFERENCE SIGNS LIST

1: element
3: substrate
5a: first transparent electrode part
5b: second transparent electrode part
7: electron transport layer
9: perovskite layer (photoactive layer, light absorbing layer)
11: hole transport layer
13: back-side electrode
13a: electrode main body part
13b: electrode connecting part
13c: bridge

**Claims**

1. An element comprising:

    a substrate (3);
    a transparent electrode (5a, 5b) provided on the substrate (3);
    a photoelectric conversion layer (7, 9, 11); and
    a back-side electrode (13),
    wherein the transparent electrode (5) includes a first transparent electrode part (5a) and a second transparent electrode part (5b) which are spatially separated from each other,
    the photoelectric conversion layer (7, 9, 11) is formed on the first transparent electrode part (5a), and
    the back-side electrode (13) comprises:

        an electrode main body part (13a) which is present on the photoelectric conversion layer (11);
        an electrode connecting part (13b) which contacts the second transparent electrode part (5b); and
        a bridge (13c) that connects the electrode main body part (13a) and the electrode connecting part (13b) .

2. The element according to claim 1, wherein when the width of the electrode main body part is W, the width ($W_B$) of the bridge is 0.01 W to 0.8 W.

3. The element according to claim 1 or 2, wherein the average layer thickness of the back-side electrode (13) is 20 nm to 250 nm.

4. The element according to any one of claims 1 to 3, wherein the back-side electrode (13) contains gold, and the average layer thickness of the back-side electrode (13) is 100 nm to 200 nm.

5. The element according to any one of claims 1 to 4, wherein the element further comprises a sealing material layer that covers the transparent electrode and the back-side electrode.

6. The element according to any one of claims 1 to 5, wherein the photoelectric conversion layer comprises:

    an electron transport layer (7);
    a perovskite layer (9); and
    a hole transport layer (11).

7. The element according to claim 6, wherein the electrode main body part (13a) and the bridge (13c) do not contact the first transparent electrode part and the electron transport layer (7).

8. A solar cell comprising the element according to any one of claims 1 to 7.

Fig.1

(a)

(b)

**EP 3 836 239 A1**

<table>
<tr><td colspan="2">INTERNATIONAL SEARCH REPORT</td><td>International application No.<br>PCT/JP2020/030488</td></tr>
</table>

**A. CLASSIFICATION OF SUBJECT MATTER**
Int.Cl. H01L51/44(2006.01)i, H05B33/06(2006.01)i
FI: H01L31/04130, H01L31/04112Z, H05B33/06

According to International Patent Classification (IPC) or to both national classification and IPC

**B. FIELDS SEARCHED**

Minimum documentation searched (classification system followed by classification symbols)
Int.Cl. H01L51/42-51/56, H01L31/00-31/20, H05B33/00-33/28

Documentation searched other than minimum documentation to the extent that such documents are included in the fields searched
Published examined utility model applications of Japan     1922-1996
Published unexamined utility model applications of Japan     1971-2020
Registered utility model specifications of Japan     1996-2020
Published registered utility model applications of Japan     1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2018-98223 A (RICOH CO., LTD.) 21 June 2018<br>(2018-06-21), paragraphs [0027], [0077], [0080],<br>[0081], [0093], fig. 1A | 1, 3-8<br>2 |
| X<br>A | JP 2011-175779 A (PANASONIC ELECTRIC WORKS CO.,<br>LTD.) 08 September 2011 (2011-09-08), paragraphs<br>[0016]-[0021], [0029], fig. 1-3, 6 | 1-5<br>6-8 |
| A | WO 2019/006507 A1 (NEWSOUTH INNOVATIONS PTY<br>LIMITED) 10 January 2019 (2019-01-10) | 1-8 |

☐ Further documents are listed in the continuation of Box C.     ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    21 October 2020 | Date of mailing of the international search report<br>    02 November 2020 |
|---|---|
| Name and mailing address of the ISA/<br>    Japan Patent Office<br>    3-4-3, Kasumigaseki, Chiyoda-ku,<br>    Tokyo 100-8915, Japan | Authorized officer<br><br><br>Telephone No. |

Form PCT/ISA/210 (second sheet) (January 2015)

| INTERNATIONAL SEARCH REPORT | International application No. |
|---|---|
| Information on patent family members | PCT/JP2020/030488 |

JP 2018-98223 A    21 June 2018    (Family: none)

JP 2011-175779 A  08 September 2011  (Family: none)

WO 2019/006507 A1 10 January 2019   TW 201917920 A

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018163938 A
- JP 2017123352 A
- JP 2015071619 A

**Non-patent literature cited in the description**

- *J. Phys. D.: Appl. Phys.,* 2008, vol. 41, 102002